# EUROPÄISCHE PATENTSCHRIFT

(11) **EP 2 480 701 B1**
(45) Veröffentlichungstag und Bekanntmachung des Hinweises auf die Patenterteilung: **27.12.2017**
(21) Anmeldenummer: 10745284.9
(22) Anmeldetag: 26.08.2010
(51) Int. Cl.: C23C 28/02, C23C 14/00, C23C 14/08, C23C 14/16, C23C 30/00

(54) **WERKZEUGBESCHICHTUNG**
TOOL COATING
REVÊTEMENT D'OUTIL

(30) Priorität: 23.09.2009 DE 102009044927
(43) Veröffentlichungstag der Anmeldung: 01.08.2012
(73) Patentinhaber: Walter AG, 72072 Tübingen (DE)
(72) Erfinder: SCHIER, Veit, 70771 Leinfelden-Echterdingen (DE)
(74) Vertreter: WSL Patentanwälte Partnerschaft mbB
(86) Internationale Anmeldenummer: PCT/EP2010/062511
(87) Internationale Veröffentlichungsnummer: WO 2011/036022

(56) Entgegenhaltungen:
- EP-A1- 1 806 192
- WO-A2-2008/008207
- DE-A1- 19 651 592
- JIANMING X ET AL: "The corrosion properties of Al/Al2O3 multilayered coatings on CK45 steel deposited by IBAD" SURFACE AND COATINGS TECHNOLOGY, Bd. 187, Nr. 2-3, 9. April 2004 (2004-04-09), Seiten 194-198, XP004572812 ELSEVIER, AMSTERDAM [NL] ISSN: 0257-8972 DOI: 10.1016/J.SURFCOAT.2004.02.021

## Beschreibung

Die vorliegende Erfindung betrifft eine Beschichtung für Schneidwerkzeuge, ein mit einer solchen Beschichtung versehenes Schneidwerkzeug sowie ein Verfahren zur Herstellung von erfindungsgemäß beschichteten Schneidwerkzeugen.

### Hintergrund der Erfindung

Beschichtete Schneidwerkzeuge, zu denen auch insbesondere Wechselschneideinsätze und Schneidplatten zählen, bestehen aus einem Substrat oder Grundkörper mit einer darauf abgeschiedenen ein- oder mehrlagigen Beschichtung, welche insbesondere dem Verschleißschutz dient, aber auch Dekor- und Indikatorfunktionen haben kann. Das Substrat besteht üblicherweise aus Stahl, Hartmetall oder Cermet und die Beschichtung wird im CVD-Verfahren oder PVD-Verfahren aufgebracht. Die Beschichtung soll die Schneideigenschaften des Werkzeugs für eine bestimmte Anwendung verbessern und/oder den Verschleiß des Werkzeugs verringern. Beschichtungen für Schneidwerkzeuge, die zumeist äußere Lagen mit einer Dekor- und/oder Indikatorfunktion umfassen, sind im Stand der Technik bekannt.
Die EP 1 762 638 beschreibt einen Schneideinsatz aus einem Hartmetallsubstrat und einer mehrlagigen Hartstoffbeschichtung für den Verschleißschutz sowie einer äußersten Lage aus ZrN, die zunächst in einer Dicke von <1 µm mittels PVD aufgetragen wird und dann von der Spanfläche und der Schneidkante durch Bürsten oder Strahlbehandlung wieder entfernt wird. Die Abnutzung der äußeren Lage ist ein Indikator dafür, ob und wie intensiv ein Werkzeug bereits genutzt wurde. Die DE 10 2004 010 285 und die DE 100 48 899 beschreiben ebenfalls Schneidwerkzeuge mit einer Indikatordeckschicht aus goldgelbem TiN oder auch aus TiC, HfC oder HfN, die sich farblich von der darunter angeordneten Verschleißschutzschicht unterscheiden und es ermöglichen sollen, ein benutztes Schneidwerkzeug von einem unbenutzten mit dem bloßen Auge zu unterscheiden Aus WO 2008/008207 A ist ein beschichtetes Schneidwerkzeug bekannt, bei dem eine äußere Schicht durch PVD aus Titan oder einer Titan-Aluminiumlegierung aufgebracht wird. Anschließend wird die Schicht anodisch oxidiert, wodurch eine farbige Indikatorschicht entsteht.

Aus DE 196 51 592 A ist ein weiteres beschichtetes Werkzeug bekannt, auf dessen Oberfläche eine 1 bis 6 µm starke Grundschicht aus Titanaluminiumnitrid aufgebracht ist. Auf diese Schicht folgt eine Zwischenschicht aus Titanaluminium von < 500 nm Dicke. Es folgt eine Außenschicht aus Aluminiumoxid, die zwischen 1 und 6 µm dick ist. Alle Schichten sind durch PVD aufgebracht. Die bei Schneideinsätzen am häufigsten eingesetzte äußere harte Verschleißschutzschicht ist eine Lage aus Aluminiumoxid, die im CVD- oder PVD-Verfahren abgeschieden wird. Über dieser wird die Deckschicht mit Dekor- und/oder Indikatorfunktion aufgebracht. Ein Nachteil der bekannten Deckschichten aus ZrN, TiN, TiC, HfC oder HfN besteht darin, dass zum Aufbringen dieser Schichten im PVD-Verfahren ein zusätzliches Target als Quelle für die abgeschiedene Metallkomponente benötigt wird, da für das Aufbringen der Verschleißschutzbeschichtung häufig keine Quelle für dieses Metall vorhanden ist. Zudem wäre es vorteilhaft, als Dekor- und Indikatordeckschicht auch andere als die auffällige gelbgoldene Farbe von ZrN oder TiN zur Verfügung zu haben, um dadurch auch eine farbliche Unterscheidbarkeit verschiedener Werkzeugtypen zu ermöglichen.

### Aufgabe

Der Erfindung lag daher die Aufgabe zugrunde, eine Beschichtung für ein Schneidwerkzeug mit einer Deckschicht mit Dekor- und/oder Indikatorfunktion zur Verfügung zu stellen, die vergleichsweise einfach und kostengünstig herzustellen ist.

### Beschreibung der Erfindung

Erfindungsgemäß wird diese Aufgabe gelöst durch eine Beschichtung gemäß Anspruch 1 sowie ein entsprechendes Verfahren nach Anspruch 11. Ein entsprechendes Schneidwerkzeug ist in Anspruch 8 definiert. Bevorzugte Ausführungsformen sind in den Ansprüchen 2 bis 7, 9, 10, 12 und 13 definiert. Bei einer derartigen Beschichtung scheint die graue Farbe des Aluminiums oder der Aluminium-Legierung durch die darüber liegende an sich farblose Oxidlage hindurch, so dass das Werkzeug eine satinierte, hellgraue Oberfläche aufweist. Das Aluminiumoxid oder das Mischoxid überdeckt dabei das Aluminium vollständig und schützt es vor äußeren Einflüssen, insbesondere vor Oxidation und anderen Reaktionen beispielsweise durch Feuchtigkeit oder Handschweiß, und verhindert dadurch eine Veränderung der metallischen Schicht.
Im Sinne der vorliegenden Erfindung ist eine metallische Lage aus Aluminium oder aus einer Aluminium-Legierung eine solche aus dem reinen Metall oder der reinen Metalllegierung, wobei übliche Verunreinigungen nicht ausgeschlossen sind. Wenn die metallische Lage einen Sauerstoffanteil bis zu 10 At.-% enthält und sie ihren metallischen Charakter dadurch nicht verliert, so soll dies im Rahmen dieser der Erfindung vom Begriff der metallischen Lage umfasst sein.
Da viele vor Verschleiß schützende Beschichtungen Lagen aus Aluminiumoxid oder aus einem Mischoxid, welches Aluminium und wenigstens ein weiteres Metall enthält, aufweisen, ist in der Regel in einer PVD-Apparatur zur Aufbringung derartiger Beschichtungen bereits ein entsprechendes Aluminium-Target oder ein gemischtes Target mit Aluminium und einem weiteren Metall oder ein Aluminium-Target und ein weiteres Metall-Target vorhanden, so dass eine erfindungsgemäße Deckschicht über der Verschleißschicht einfach aufbringbar ist, ohne dass ein Wechsel des oder der Targets in der PVD-Apparatur erforderlich ist.
Ein weiterer Vorteil der erfindungsgemäßen Deckschicht in der Beschichtung besteht darin, dass diese gut durch mechanische Abtragungsverfahren, beispielsweise Strahlbehandlung mit einem partikulären Strahlmittel oder durch Bürsten, entfernbar ist. Die Erfindung weist in der Deckschicht die erste Lage aus Aluminium oder einer Aluminium-Legierung eine Schichtdicke von 10 nm bis 500 nm, bevorzugt 20 nm bis 70 nm auf. Die zweite Lage aus Aluminiumoxid oder einem Mischoxid, welches Aluminium und wenigstens ein weiteres Metall enthält, weist eine Schichtdicke von 5 nm bis 100 nm, bevorzugt 10 nm bis 50 nm, auf. Beispielsweise besteht die Deckschicht vorzugsweise aus einer 50 nm dicken ersten Lage aus metallischem Aluminium, gefolgt von einer 20 nm dicken zweiten Lage aus Aluminiumoxid.

Weiter weist die Beschichtung unter der Deckschicht wenigstens eine metallische Hartstofflage als Verschleißschutzschicht auf, vorzugsweise eine Hartstofflage aus Aluminiumoxid. Eine dreilagige Beschichtung, die als Metallkomponente nur Aluminium enthält, kann kostengünstig unter Verwendung eines einzigen Targets für alle Lagen der Beschichtung im PVD-Verfahren hergestellt werden. In weiteren Ausführungsformen der Erfindung umfasst die Beschichtung weitere Hartstofflagen als Verschleißschutzschichten auf. Bevorzugte Hartstofflagen sind beispielsweise Lagen aus TiAlN, AlCrN, oder Mischungen davon, auch solche, die Si enthalten. In einer bevorzugten Ausführungsform haben die als Verschleißschutzschichten vorgesehenen Hartstofflagen eine Schichtdicke von 0,5 bis 10 µm, vorzugsweise von 1,0 bis 5 µm, besonders bevorzugt etwa 3 µm. Darüber kann dann beispielsweise eine Aluminiumoxid-Schicht angeordnet sein mit einer Schichtdicke von beispielsweise 1 µm, gefolgt von der erfindungsgemäßen Deckschicht mit einer ersten Lage aus metallischem Aluminium oder einer Aluminium-Legierung und einer darüber angeordneten zweiten Lage aus Aluminiumoxid oder einem Mischoxid, welches Aluminium und wenigstens ein weiteres Metall enthält.

Ganz besonderst bevorzugt besteht in der erfindungsgemäßen Beschichtung die erste Lage der äußeren Deckschicht aus metallischem Aluminium und/oder die darüber angeordnete zweite Lage aus Aluminiumoxid. Diese Schichtfolge ist mit nur einem Aluminium-Target im PVD-Verfahren mit Vorteil herstellbar.

In einer alternativen Ausführungsform besteht in der erfindungsgemäßen Beschichtung die erste Lage der äußeren Deckschicht aus Aluminium-Chrom-Legierung und/oder die darüber angeordnete zweite Lage aus Aluminium-Chrom-Oxid (AlCr)₂O₃. Weitere Legierungen und Mischoxide mit Aluminium mit anderen Metallen lassen sich vom Fachmann leicht herstellen und sollen vom Umfang der Erfindung erfasst sein.

In einer Ausführungsform der Erfindung weist in der Beschichtung die äußere Deckschicht wenigstens zweimal, vorzugsweise mehrfach übereinander eine Lagenabfolge aus einer ersten Lage aus metallischem Aluminium oder einer Aluminium-Legierung und einer darüber angeordneten zweiten Lage aus Aluminiumoxid oder einem Mischoxid, welches Aluminium und wenigstens ein weiteres Metall enthält, auf. Bei dieser Ausführungsform enthält die Deckschicht somit mehrfach abwechselnd metallische Lagen und Oxidlagen.

In einer weiteren Ausführungsform der Erfindung weist in der Beschichtung die äußere Deckschicht über der äußersten Oxidlage aus Aluminiumoxid oder einem Mischoxid eine weitere Lage aus metallischem Aluminium oder einer Aluminium-Legierung auf. Eine solche äußere metallische Lage dient überwiegend als dekorative bzw. Verschleißanzeigelage, da sie nicht abriebfest ist. Im Gebrauch des Schneidwerkzeugs wird sie bei Kontakt mit dem Werkstück schnell abgerieben werden.

Die Erfindung umfasst auch ein Schneidwerkzeug, welches aus einem Substrat oder Grundkörper mit einer darauf abgeschiedenen ein- oder mehrlagigen erfindungsgemäßen Beschichtung besteht. Das Substrat bzw. der Grundkörper besteht vorzugsweise aus Hartmetall, Cermet, Keramik oder Stahl.

In einer Ausführungsform des erfindungsgemäßen Schneidwerkzeugs ist die äußere Deckschicht nur auf ausgewählten Bereichen des Werkzeugs in/auf der Beschichtung vorhanden. Eine solche Anordnung der Deckschicht kann dadurch hergestellt werden, dass man die Deckschicht nur auf ausgewählten Bereichen des Werkzeugs aufbringt, was im üblichen PVD-Abscheidungsverfahren jedoch schwierig ist. Vorzugsweise wird die äußere Deckschicht vollständig aufgebracht und nach dem Aufbringen von ausgewählten Bereichen des Werkzeugs von der Beschichtung wieder entfernt.

Schneidwerkzeuge, wie Schneidplatten zur Metallbearbeitung, weisen anstoßend an eine Schneidkante eine Spanfläche und eine Freifläche auf. Bei besonders bevorzugten Ausführungsformen der erfindungsgemäßen Schneidwerkzeuge der vorgenannten Art ist die Beschichtung auf der Spanfläche und/oder der Schneidkante wenigstens teilweise, vorzugsweise vollständig frei von äußerer Deckschicht. Dadurch sind Abschnitte des Schneidwerkzeugs, die besonders mechanisch beansprucht werden und mit dem Werkstück in Berührung treten, frei von der Deckschicht mit der Dekor- und/oder Indikatorfunktion. Die Deckschicht würde bei entsprechender mechanischer Belastung sehr schnell abgetragen werden. Darüber hinaus kann die Deckschicht auf der Spanfläche und gegebenenfalls auch auf der Schneidkante unerwünschte Reibungs- und Schmiereffekte haben. Im Gegensatz dazu sind Abschnitte des Schneidwerkzeugs, die einer geringen oder keiner mechanischen Belastung ausgesetzt sind, durch die Deckschicht vor Korrosion geschützt. Des weiteren hat die Deckschicht auf diesen Abschnitten eine Dekor- und/oder Indikatorfunktion und zeigt eine Benutzung des Schneidwerkzeugs an, da die Deckschicht auch bei geringer Belastung schon Abriebspuren zeigt, wie beispielsweise in Bereichen der Freifläche in der Nähe der Schneidkante.

Weiterhin umfasst die Erfindung auch ein Verfahren zur Herstellung des hierin beschriebenen beschichteten Schneidwerkzeugs, bei dem man auf einem Substrat oder Grundkörper eine mehrlagige Beschichtung der hierin beschriebenen Art durch CVD- und/oder PVD-Verfahren aufbringt, wobei die äußere Deckschicht mit der ersten Lage aus metallischem Aluminium oder einer Aluminium-Legierung und der darüber angeordneten zweiten Lage aus Aluminiumoxid oder einem Mischoxid, welches Aluminium und wenigstens ein weiteres Metall enthält, im PVD-Verfahren mit wenigstens einem Aluminium enthaltenden Target aufgebracht wird.

Zum Aufbringen der Deckschicht können im Wesentlichen alle bekannten PVD-Verfahren eingesetzt werden, wie beispielsweise duales Magnetronsputtern, reaktives Magnetronsputtern, Lichtbogenverdampfen (ARC), gepulstes Lichtbogenverdampfen (ARC) oder HIPIMS (High Power Impulse Magnetron. Sputtering).

Das PVD-Verfahren wird zweckmäßigerweise unter Inertgasatmosphäre, vorzugsweise Argon, durchgeführt, wobei zur Abscheidung von Aluminiumoxid Sauerstoff als Reaktivgas zugemischt wird.

In einer weiteren bevorzugten Ausführungsform der Erfindung wird in einer anschließenden Verfahrensstufe die äußere Deckschicht mit der ersten Lage aus metallischem Aluminium oder einer Aluminium-Legierung und der darüber angeordneten zweiten Lage aus Aluminiumoxid oder einem Mischoxid, welches Aluminium und wenigstens ein weiteres Metall enthält, durch ein mechanisches Abtragungsverfahren von ausgewählten Oberflächenbereichen des Schneidwerkzeugs wieder entfernt. Insbesondere wird in dieser Verfahrensstufe die äußere Deckschicht von den Spanflächen und/oder den Schneidkanten eines Schneidwerkzeugs entfernt.

Bevorzugt ist das mechanische Abtragungsverfahren Bürsten oder ein abrasives Strahlverfahren mit einem partikulären Strahlmittel, beispielsweise Quarzsand oder Korund.

Weitere Vorteile, Merkmale und Anwendungsmöglichkeiten der vorliegenden Erfindung werden deutlich anhand der folgenden Beschreibung einer Figur und bevorzugter Ausführungsformen.

### Figur 1

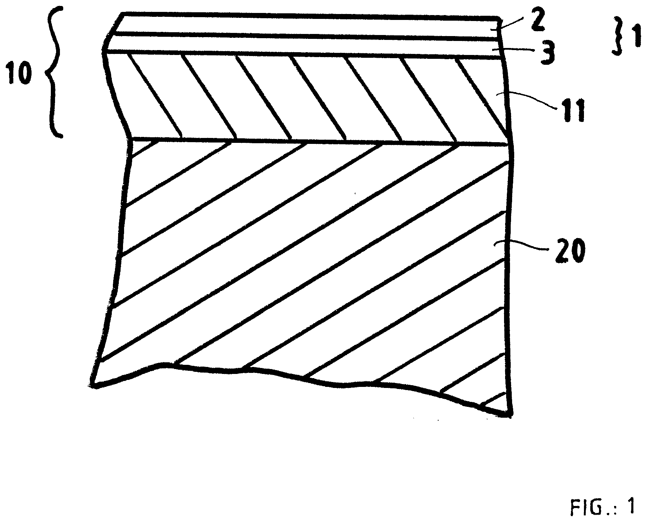

Figur 1 zeigt eine schematische abgebrochene Schnittsdarstellung eines Schneidwerkzeugs mit erfindungsgemäßer Beschichtung. Die Darstellung ist in starker Vergrößerung und nicht maßstabsgetreu.

Auf dem Substrat oder Grundkörper 20 ist eine Beschichtung 10 aufgebracht. Diese Beschichtung umfasst in dieser Ausführungsform eine Verschleißschutzschicht 11, die aus einer oder mehreren Lagen bestehen kann. Insbesondere kann die Verschleißschutzschicht aus mehreren Lagen unterschiedlicher Materialien bestehen, die beispielsweise abwechselnd aufgebracht sind.

Auf der Verschleißschutzschicht 11 befindet sich eine Deckschicht 1, die aus einer ersten Lage 3 aus metallischem Aluminium und einer vom Substrat aus darüber angeordneten zweiten Lage 2 aus Aluminiumoxid besteht. Die erste Lage 3 aus metallischem Aluminium haftet auf der Verschleißschutzschicht 11, ist jedoch gut entfernbar. Die zweite Lage 2 aus Aluminiumoxid haftet gut auf der ersten Lage aus metallischem Aluminium und schützt diese vor Korrosion.

### Ausführungsbeispiel

In einer PVD-Beschichtungsanlage (Flexicoat; Hauzer Techno Coating) wurden Hartmetallsubstrate, die eine Verschleißschutzbeschichtung mit einer äußersten Lage aus Al₂O₃ aufwiesen, mit einer zweilagigen Deckschicht versehen. Vor der Abscheidung der Lagen wurde die Anlage auf 1x10⁻⁵ mbar evakuiert.

Die Abscheidung der aus zwei Lagen bestehenden Deckschicht wurde unter folgenden Bedingungen durchgeführt:

### 1. Lage: (metallisches Aluminium; Al)

▪ PVD-Verfahren: nicht-reaktives Magnetronsputtern
▪ Target: Al-Rechteckquelle (80 cm x 20 cm)
▪ Abscheidung: spezifische Kathodenleistung ca. 7 W/cm²
   0,5 Pa Ar-Druck
   30 Volt Substratvorspannung, bipolar gepulst mit 70 kHz
▪ Temperatur: 550°C
▪ Schichtdicke: 50 nm

### 2. Lage: (Aluminiumoxid; Al₂O₃)

▪ PVD-Verfahren: reaktives Magnetronsputtern
▪ Target: Al-Rechteckquelle (80 cm x 20 cm)
▪ Abscheidung: spezifische Kathodenleistung ca. 7 W/cm²
   0,5 Pa Ar-Druck, ca. 80 sccm O₂ (als Reaktivgas)
   150 Volt Substratvorspannung, bipolar gepulst mit 70 kHz
▪ Temperatur: 550°C
▪ Schichtdicke: 20 nm

Die beschichteten Schneidwerkzeuge wiesen eine matt-graue Oberfläche auf, die durch Sandstrahlen leicht zu entfernen war.

Für Zwecke der ursprünglichen Offenbarung wird darauf hingewiesen, dass sämtliche Merkmale wie sie sich aus der vorliegenden Beschreibung und den abhängigen Ansprüchen für einen Fachmann erschließen, auch wenn sie konkret nur im Zusammenhang mit bestimmten weiteren Merkmale beschrieben wurden, sowohl einzeln als auch in beliebigen Zusammenstellungen mit anderen der hier offenbarten Merkmale oder Merkmalsgruppen kombinierbar sind, soweit dies nicht ausdrücklich ausgeschlossen wurde oder technische Gegebenheiten derartige Kombinationen unmöglich oder sinnlos machen. Auf die umfassende, explizite Darstellung sämtlicher denkbarer Merkmalskombinationen wird hier nur der Kürze und der Lesbarkeit der Beschreibung wegen verzichtet.

## Patentansprüche

1. Beschichtung (10) auf einem Substrat oder Grundkörper (20) für ein Schneidwerkzeug, welche mehrere übereinander angeordnete Lagen umfasst, wobei
die Beschichtung eine äußere Deckschicht (1) mit einer ersten Lage (3) aus metallischem Aluminium oder einer Aluminium-Legierung mit einer Schichtdicke von 10 nm bis 500 nm und
einer darüber angeordneten zweiten Lage (2) aus Aluminiumoxid oder einem Mischoxid, welches Aluminium und wenigstens ein weiteres Metall enthält, mit einer Schichtdicke von 5 nm bis 100 nm aufweist und
die Beschichtung unter der Deckschicht wenigstens eine metallische Hartstofflage als Verschleißschutzschicht (11) aufweist und
die äußere Deckschicht (1) mit der ersten Lage (3) aus metallischem Aluminium oder einer Aluminium-Legierung und der darüber angeordneten zweiten Lage (2) aus Aluminiumoxid oder einem Mischoxid, welches Aluminium und wenigstens ein weiteres Metall enthält, im PVD-Verfahren mit wenigstens einem Aluminium enthaltenden Target hergestellt ist.

2. Beschichtung nach Anspruch 1, **dadurch gekennzeichnet, dass** die erste Lage (3) aus Aluminium oder einer Aluminium-Legierung eine Schichtdicke von 20 nm bis 70 nm aufweist und die zweite Lage (2) aus Aluminiumoxid oder einem Mischoxid, welches Aluminium und wenigstens ein weiteres Metall enthält, eine Schichtdicke von 10 nm bis 50 nm, aufweist.

3. Beschichtung nach Anspruch 1 oder 2, **dadurch gekennzeichnet, dass** die Beschichtung unter der Deckschicht wenigstens eine metallische Hartstofflage aus Aluminiumoxid als Verschleißschutzschicht (11) aufweist.

4. Beschichtung nach einem der vorangegangenen Ansprüche, **dadurch gekennzeichnet, dass** die erste Lage (3) der äußeren Deckschicht (1) aus metallischem Aluminium besteht und/oder die darüber angeordnete zweite Lage (2) aus Aluminiumoxid besteht.

5. Beschichtung nach einem der Ansprüche 1 bis 3, **dadurch gekennzeichnet, dass** die erste Lage (3) der äußeren Deckschicht (1) aus Aluminium-Chrom-Legierung besteht und/oder die darüber angeordnete zweite Lage (2) aus Aluminium-Chrom-Oxid (AlCr)₂O₃ besteht.

6. Beschichtung nach einem der vorangegangenen Ansprüche, **dadurch gekennzeichnet, dass** die äußere Deckschicht (1) wenigstens zweimal, vorzugsweise mehrfach übereinander eine Lagenabfolge aus einer ersten Lage aus metallischem Aluminium oder einer Aluminium-Legierung und einer darüber angeordneten zweiten Lage aus Aluminiumoxid oder einem Mischoxid, welches Aluminium und wenigstens ein weiteres Metall enthält, aufweist.

7. Beschichtung nach einem der vorangegangenen Ansprüche, **dadurch gekennzeichnet, dass** die äußere Deckschicht (1) über der äußersten Oxidlage aus Aluminiumoxid oder einem Mischoxid eine weitere Lage aus metallischem Aluminium oder einer Aluminium-Legierung aufweist.

8. Schneidwerkzeug, bestehend aus einem Substrat oder Grundkörper (20), vorzugsweise aus Hartmetall, Cermet, Keramik oder Stahl, mit einer darauf abgeschiedenen ein- oder mehrlagigen Beschichtung (10) nach einem der vorangegangenen Ansprüche.

9. Schneidwerkzeug nach Anspruch 8, **dadurch gekennzeichnet, dass** die äußere Deckschicht (1) nur auf ausgewählten Bereichen des Werkzeugs in/auf der Beschichtung (10) vorhanden ist und/oder die äußere Deckschicht (1) nach dem Aufbringen von ausgewählten Bereichen des Werkzeugs von der Beschichtung (10) wieder entfernt wurde.

10. Schneidwerkzeug nach einem der Ansprüche 8 oder 9, **dadurch gekennzeichnet, dass** die Beschichtung (10) auf der Spanfläche und/oder der Schneidkante wenigstens teilweise oder vollständig frei von äußerer Deckschicht (1) ist.

11. Verfahren zur Herstellung eines beschichteten Schneidwerkzeugs, bei dem man auf einem Substrat oder Grundkörper (20) eine mehrlagige Beschichtung (10) nach einem der vorangegangenen Ansprüche durch CVD- und/oder PVD-Verfahren aufbringt, **dadurch gekennzeichnet, dass** die äußere Deckschicht (1) mit der ersten Lage (3) aus metallischem Aluminium oder einer Aluminium-Legierung und der darüber angeordneten zweiten Lage (2) aus Aluminiumoxid oder einem Mischoxid, welches Aluminium und wenigstens ein weiteres Metall enthält, im PVD-Verfahren mit wenigstens einem Aluminium enthaltenden Target aufgebracht wird.

12. Verfahren nach Anspruch 11, **dadurch gekennzeichnet, dass** in einer anschließenden Verfahrensstufe die äußere Deckschicht (1) mit der ersten Lage (3) aus metallischem Aluminium oder einer Aluminium-Legierung und der darüber angeordneten zweiten Lage (2) aus Aluminiumoxid oder einem Mischoxid, welches Aluminium und wenigstens ein weiteres Metall enthält, durch ein mechanisches Abtragungsverfahren von ausgewählten Oberflächenbereichen des Schneidwerkzeugs wieder entfernt wird.

13. Verfahren nach Anspruch 12, **dadurch gekennzeichnet, dass** das mechanische Abtragungsverfahren Bürsten oder ein abrasives Strahlverfahren mit einem partikulären Strahlmittel ist.

## Claims

1. A coating (10) on a substrate or a main body (20) for a cutting tool, which includes a plurality of mutually superposed layer portions, wherein
the coating has an outer cover layer (1) with a first layer portion (3) of metallic aluminium or an aluminium alloy of a layer thickness of 10 nm to 500 nm, and
a second layer portion (2) arranged thereover of aluminium oxide or a mixed oxide which contains aluminium and at least one further metal of a layer thickness of 5 nm to 100 nm, and
the coating under the cover layer has at least one metallic hard material layer portion as a wear protection layer (11), and
the outer cover layer (1) with the first layer portion (3) of metallic aluminium or an aluminium alloy and the second layer portion (2) arranged thereover of aluminium oxide or a mixed oxide which contains aluminium and at least one further metal is produced in the PVD process with at least one aluminium-containing target.

2. A coating according to claim 1 **characterised in that** the first layer portion (3) of aluminium or an aluminium alloy is of a layer thickness of 20 nm to 70 nm, and the second layer portion (2) of aluminium oxide or a mixed oxide which contains aluminium and at least one further metal is of a layer thickness of 10 nm to 50 nm.

3. A coating according to claim 1 or claim 2 **characterised in that** the coating under the cover layer has at least one metallic hard material layer portion of aluminium oxide as a wear protection layer (11).

4. A coating according to one of the preceding claims **characterised in that** the first layer portion (3) of the outer cover layer (1) comprises metallic aluminium and/or the second layer portion (2) arranged thereover comprises aluminium oxide.

5. A coating according to one of claims 1 to 3 **characterised in that** the first layer portion (3) of the outer cover layer (1) comprises aluminium-chromium alloy and/or the second layer portion (2) arranged thereover comprises aluminium-chromium oxide (AlCr)₂O₃.

6. A coating according to one of the preceding claims **characterised in that** the outer cover layer (1) has at least twice and preferably a plurality of times in mutually superposed relationship a layer portion succession comprising a first layer portion of metallic aluminium or an aluminium alloy and a second layer portion arranged thereover of aluminium oxide or a mixed oxide which contains aluminium and at least one further metal.

7. A coating according to one of the preceding claims **characterised in that** the outer cover layer (1) over the outermost oxide layer portion of aluminium oxide or a mixed oxide has a further layer portion of metallic aluminium or an aluminium alloy.

8. A cutting tool comprising a substrate or main body (20), preferably of cemented carbide, cermet, ceramic or steel, with a single-layer or multi-layer coating (10) deposited thereon according to one of the preceding claims.

9. A cutting tool according to claim 8 **characterised in that** the outer cover layer (1) is present only on selected regions of the tool in/on the coating (10) and/or the outer cover layer (1) was removed from the coating (10) again after the application of selected regions of the tool.

10. A cutting tool according to one of claims 8 or 9 **characterised in that** the coating (10) is at least partially or completely free of outer cover layer (1) on the rake face and/or the cutting edge.

11. A process for the production of a coated cutting tool in which a multi-layer coating (10) according to one of the preceding claims is applied by CVD and/or PVD processes to a substrate or main body (20), **characterised in that** the outer cover layer (1) with the first layer portion (3) of metallic aluminium or an aluminium alloy and the second layer portion (2) arranged thereover of aluminium oxide or a mixed oxide which contains aluminium and at least one further metal is applied in the PVD process with at least one aluminium-containing target.

12. A process according to claim 11 **characterised in that** in a subsequent process step the outer cover layer (1) with the first layer portion (3) of metallic aluminium or an aluminium alloy and the second layer portion (2) arranged thereover of aluminium oxide or a mixed oxide which contains aluminium and at least one further metal is removed from selected surface regions of the cutting tool again by a mechanical abrasion process.

13. A process according to claim 12 **characterised in that** the mechanical abrasion process is brushing or an abrasive blasting process with a particulate blasting agent.

## Revendications

1. Revêtement (10) implanté sur un substrat ou sur un corps de base (20), dévolu à un outil de coupe et composé de plusieurs strates placées en superposition,
ledit revêtement comportant une couche extérieure de recouvrement (1) comprenant une première strate (3) en aluminium métallique ou en un alliage d'aluminium, présentant une épaisseur de couche de 10 nm à 500 nm, et
une seconde strate sus-jacente (2) en oxyde d'aluminium, ou en un oxyde mixte renfermant de l'aluminium et au moins un autre métal, présentant une épaisseur de couche de 5 nm à 100 nm,
ledit revêtement étant muni, sous ladite couche de recouvrement, d'au moins une strate de matériau métallique dur en tant que couche (11) de protection contre l'usure, et
ladite couche extérieure de recouvrement (1), constituée de ladite première strate (3) en aluminium métallique ou en un alliage d'aluminium, et de ladite seconde strate sus-jacente (2) en oxyde d'aluminium ou en un oxyde mixte renfermant de l'aluminium et au moins un autre métal, étant fabriquée suivant le procédé PVD impliquant au moins une cible contenant de l'aluminium.

2. Revêtement selon la revendication 1, **caractérisé par le fait que** la première strate (3) en aluminium ou en un alliage d'aluminium présente une épaisseur de couche de 20 nm à 70 nm, et la seconde strate (2) en oxyde d'aluminium, ou en un oxyde mixte renfermant de l'aluminium et au moins un autre métal, présente une épaisseur de couche de 10 nm à 50 nm.

3. Revêtement selon la revendication 1 ou 2, **caractérisé par le fait que** ledit revêtement comporte, sous la couche de recouvrement, au moins une strate de matériau métallique dur en oxyde d'aluminium qui constitue une couche (11) de protection contre l'usure.

4. Revêtement selon l'une des revendications précédentes, **caractérisé par le fait que** la première strate (3) de la couche extérieure de recouvrement (1) consiste en de l'aluminium métallique, et/ou la seconde strate sus-jacente (2) consiste en de l'oxyde d'aluminium.

5. Revêtement selon l'une des revendications 1 à 3, **caractérisé par le fait que** la première strate (3) de la couche extérieure de recouvrement (1) consiste en un alliage d'aluminium-chrome, et/ou la seconde strate sus-jacente (2) consiste en de l'oxyde d'aluminium-chrome (AlCr)₂O₃.

6. Revêtement selon l'une des revendications précédentes, **caractérisé par le fait que** la couche extérieure de recouvrement (1) comporte, en une superposition au moins double et préférentiellement multiple, une succession de strates composée d'une première strate en aluminium métallique ou en un alliage d'aluminium, et d'une seconde strate sus-jacente en oxyde d'aluminium ou en un oxyde mixte renfermant de l'aluminium et au moins un autre métal.

7. Revêtement selon l'une des revendications précédentes, **caractérisé par le fait que** la couche extérieure de recouvrement (1) comporte, au-dessus de la strate d'oxyde la plus extérieure constituée d'oxyde d'aluminium ou d'un oxyde mixte, une strate supplémentaire en aluminium métallique ou en un alliage d'aluminium.

8. Outil de coupe comprenant un substrat ou un corps de base (20) préférentiellement constitué d'un métal dur, d'un cermet, d'une céramique ou d'un acier, sur lequel est déposé un revêtement (10) à une ou plusieurs strate(s), conforme à l'une des revendications précédentes.

9. Outil de coupe selon la revendication 8, **caractérisé par le fait que** la couche extérieure de recouvrement (1) est présente, dans/sur le revêtement (10), uniquement dans des régions sélectionnées dudit outil ; et/ou ladite couche extérieure de recouvrement (1) a été de nouveau éliminée dudit revêtement (10) à l'issue du dépôt sur des régions sélectionnées dudit outil.

10. Outil de coupe selon l'une des revendications 8 ou 9, **caractérisé par le fait que** le revêtement (10) est exempt de couche extérieure de recouvrement (1), au moins en partie ou en totalité, sur la surface d'enlèvement de copeaux et/ou sur l'arête de coupe.

11. Procédé de fabrication d'un outil de coupe revêtu, dans lequel un revêtement (10) à strates multiples, conforme à l'une des revendications précédentes, est déposé sur un substrat ou sur un corps de base (20) par un (des) procédé(s) CVD et/ou PVD, **caractérisé par le fait que** la couche extérieure de recouvrement (1), constituée de la première strate (3) en aluminium métallique ou en un alliage d'aluminium, et de la seconde strate sus-jacente (2) en oxyde d'aluminium ou en un oxyde mixte renfermant de l'aluminium et au moins un autre métal, est déposée suivant le procédé PVD impliquant au moins une cible contenant de l'aluminium.

12. Procédé selon la revendication 11, **caractérisé par le fait que**, durant une phase opératoire consécutive, la couche extérieure de recouvrement (1), composée de la première strate (3) en aluminium métallique ou en un alliage d'aluminium, et de la seconde strate sus-jacente (2) en oxyde d'aluminium ou en un oxyde mixte renfermant de l'aluminium et au moins un autre métal, est de nouveau éliminée, par un procédé d'érosion mécanique, de régions sélectionnées de la surface de l'outil de coupe.

13. Procédé selon la revendication 12, **caractérisé par le fait que** le procédé d'érosion mécanique se présente comme des brosses, ou comme un procédé de projection abrasive impliquant un agent projeté particulaire.
